# EUROPEAN PATENT APPLICATION

(11) **EP 0 614 221 A1**
(43) Date of publication of application: **07.09.1994**
(21) Application number: 94103100.7
(22) Date of filing: 02.03.1994
(51) Int. Cl.: H01L 23/64, H01L 23/66

(54) **Integrated transmission line structure**

(30) Priority: 05.03.1993 JP 44190/93
(71) Applicant: FUJITSU LIMITED, Kawasaki-shi, Kanagawa 211 (JP)
(72) Inventor: Fukushima, Sachiko, c/o Fujitsu Limited, Nakahara-ku, Kawasaki-shi, Kanagawa 211 (JP)
(74) Representative: Stebbing, Timothy Charles

(57) **Abstract**

The integrated transmission line structure comprises a substrate (1) having alternating grooves (12) and projections (11). Transmission lines (2) are formed on the projections, and may also be formed in the grooves. Due to separating adjacent transmission lines by a distance (A) greater than the horizontal distance (B) between them, cross-talk characteristics of the transmission lines are improved.

The substrate can be engaged with an encapsulating substrate (3), having a shape complementary to that of the substrate and provided with a conductor layer, so as to further improve the shielding between adjacent transmission lines.

The structure can be incorporated with a chip carrier or multi-chip module.

## Description

The present invention relates to transmission lines formed on a surface of a substrate of integrated circuits, and more specifically to parallel signal transmission lines formed on a recessed surface of the substrate to reduce cross-talk between neighboring transmission lines.

In general, as active and passive elements in high density integrated circuits become increasingly smaller, a spacing between neighboring transmission lines becomes increasingly narrower. This results in cross-talk, i.e. a signal carried on a line leaks to the neighboring transmission line by electrostatic coupling between the lines. The electrostatic coupling also increases with higher frequency of signals on the line. Thus, the cross-talk has become progressively an unavoidable obstacle to develop higher-speed and higher-packing density integrated circuits. Particularly, in a recent optoelectronic multi-chip module, parallel electric signal transmission lines are often aligned with parallel optical fibers. Each of these transmission lines is connected with each element of an array of light emitting or receiving diodes formed on a single chip carrier. Since the denser array of light emitting or receiving elements requires the narrower spacing between neighboring electric transmission lines, the cross-talk between these narrow-spacing parallel transmission lines becomes severer particularly to high-frequency signals.

A typical optoelectronic multi-chip module, which comprises an array of optoelectronic devices, parallel signal transmission lines , bonding wires connecting the optoelectronic devices with the electric transmission lines, a chip carrier , and an array of parallel optical fibers mounted on an array of the optoelectronic devices . Since the electric transmission lines are formed on a planar surface of the chip carrier with the same spacing as that between the optoelectronic devices , a static capacitance between the electronic transmission lines can not be reduced without the sacrifice of the optimized geometrical arrangement. A wider spacing between the lines resulting in a low cross-talk requires non-parallel extended bonding wires as well as a large amount of wasted chip area. Thus, both reduction of the cross-talk and the chip area at the same time is not possible in the prior art.

It is therefore desirable to provide high packing density integrated circuits having parallel signal transmission lines with low cross-talk.

It is also desirable to provide an optoelectronic integrated circuit system having parallel transmission lines with a low electroststic capacitance between neighbouring lines.

According to one aspect of the present invention, there is provided an integrated transmission line structure comprising:
a substrate having a step, the step defined by a first surface at a first level, a second surface at a second level which is higher than the first level relative to a base level of said substrate, and a side wall connecting the first surface to the second surface,
a first transmission line formed on the first surface, and
a second transmission line formed on the second surface.

According to another aspect of the present invention, there is provided an integrated transmission line structure comprising a plurality of transmission lines arranged parallel to each other on a substrate, each pair of adjacent transmission lines being separated by a groove.

The present invention also embraces an integrated module or multi-chip module incorporating either of the above structures.

Reference is made, by way of example, to the accompanying drawings in which:
FIG. 1 is a cross-sectional view of integrated transmission lines formed on an insulated substrate having parallel grooves and banks on the surface.
FIG. 2 is a cross-sectional view of integrated transmission lines formed on an insulated substrate having parallel grooves and banks for an air-gap isolation.
FIG. 3 is a cross-sectional view of integrated transmission lines formed on an insulated substrate interlocked with an encapsulating substrate having a grounded conducting layer facing to the parallel signal transmission lines.
FIG. 4 is a view of an optoelectronic multi-chip module comprising an insulated chip carrier, parallel signal transmission lines, an array of optoelectronic devices, and bonding wires connecting between each of the devices and each open end of the transmission lines.
FIGS. 5 and 6 are cross-sectional views of surface morphology obtained by anisotropic etching single crystalline semiconductor materials.

The preferred embodiments of the present invention will now be described in detail.

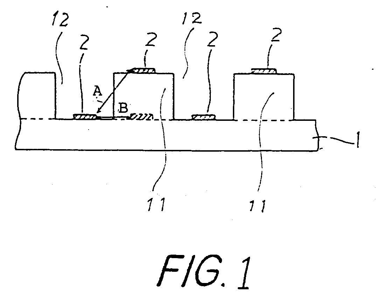

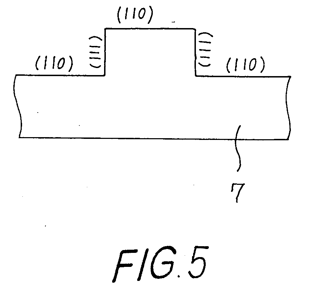

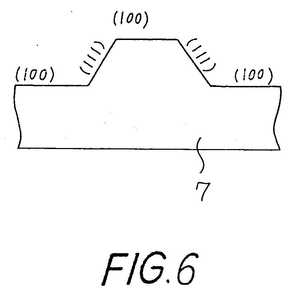

Referring to FIG. 1, there are several fabrication methods for deep grooves having steep side-walls. As shown in FIGS. 5 and 6, anisotropic etching of single crystalline silicon 7 by potassium-hydroxide ( KOH ) solution is a well known method, and the preferential etching results in several cross-sectional shapes for crystallographic orientations of the substrates. Another powerful deep-etching method is reactive ion etching (RIE) process which provides anisotropic etching to either amorphous insulating materials or single crystalline semiconducting materials by selecting etching gases. Parallel grooves and banks (projections) can be formed on a surface of an insulated chip carrier 1 by either of the following two ways; one comprises the steps of forming parallel grooves and banks on the surface of chip carrier of semiconductor crystal, and then forming an insulating layer on the entire surface of the grooves and banks by either thermal oxidation or chemical vapor deposition, or another comprises the steps of forming thick insulating layer on the entire surface of chip carrier of semiconductor crystal, and then forming parallel grooves and banks on the surface of the insulating layer. In the latter case the thickness of the initial insulating layer should be thicker than the depth of the groove. Thus parallel signal transmission lines 2 are formed on each of the bottom surface of the parallel grooves 12 and the top surface of the parallel banks 11 by either photolithography or lift-off process. Since a substantial distance denoted by A between each pair of neighboring lines can be selected larger than that in the same horizontal plane denoted by B, by forming the groove as deep as needed, the electrostatic capacitance between each pair of neighboring lines can be reduced without any extra area in the horizontal plane. What "substantial distance" means is that a physical quantity of A instead B in FIG.1 has a substantial meaning for electrostatic interaction between them. The ratio of A/B is preferably equal to or larger than 2 for allowable cross-talk.

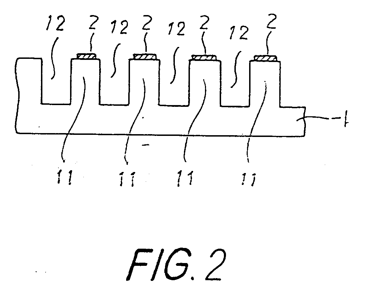

Alternatively, in FIG. 2, the parallel signal transmission lines are formed on each of the top surface of the parallel banks 11. Since the space between each pair of neighboring lines is filled with air whose dielectric constant is smaller than that of the insulating material around it, the parasitic capacitance becomes lower than that without grooves 12. For example, the reduction rate is about 0.67 for silicon dioxide (SiO₂) as the insulating material. Then the line spacing is allowed to be smaller than that without an air-gap isolation.

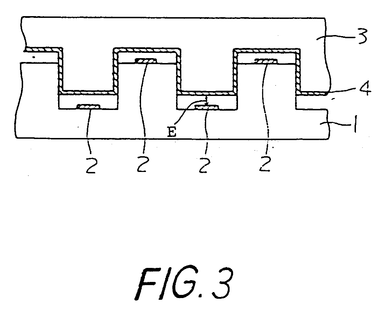

Referring to FIG. 3, a pair of insulated chip carriers may be provided, which are mutually engaged by their matching grooves and projections (banks). One substrate 1 is the same as shown in FIG. 1 and another is an encapsulating substrate 3 covered with a grounded conducting layer 4 facing the parallel signal transmission lines 2 . In this interlocked structure, the substantial distance (actual distance) between the neighboring transmission lines is larger than that in the horizontal plane as described in FIG. 1, and furthermore the grounded conducting layer shields a considerable part of the electric lines of force terminating at the neighboring transmission lines. The spacing between the conducting layer and the nearest transmission line also provides the air-gap isolation effect described in the embodiment shown in FIG. 2. Thus, the interlocked shielding chip carrier structure can give a triple effect for reducing the cross-talk.

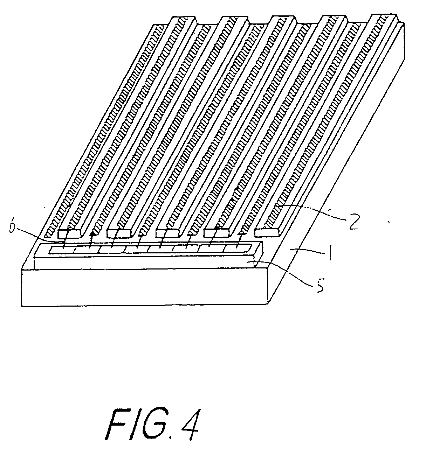

Referring to FIG. 4, an optoelectronic multi-chip module comprises an insulated chip carrier 1, parallel signal transmission lines 2, an array of optoelectronic devices 5, and bonding wires 6 connecting between each of the devices and each open end of the transmission lines. Open ends of optical fibers ( not shown ) are mounted on each of the optoelectronic devices 5. For receiving optical signals a semiconductor photo-diode can be used, while for emitting optical signals a compound semiconductor laser may be used. The bonding wires 6 are usually made of gold or aluminium, which may be replaced by a metal film patterned on the surface of the chip carrier and extending to both of the terminals,

Referring to FIG. 5 and 6, anisotropic etching of single crystalline silicon 7 can be done by potassium-hydroxide ( KOH ) solution. Masking a wafer surface having a (110) surface index gives perpendicular side-walls around the top of the masking surface as shown in FIG. 5, while a wafer surface having a (100) surface index gives declining side-walls having a (111) surface index as shown in FIG. 6.
The latter may result in grooves of V-shape or trapezoid.

It should be noticed that this technique is applicable to any groove having other shapes such as V, U, keyhole, or wave shape, and also to a groove filled with any dielectric materials such as phosphorus silicate glass ( PSG ), organic resin such as PMMA, or porous silicon or silicon oxide. The substrate is not limited to a bulk insulating material, and any conducting materials covered with an insulating layer, any insulating materials covered with a conducting layer, or laminated ones with conducting layer and insulating layer are applicable. A conducting layer serves for supplying an electric potential as well as quick dissipation of heat.

Several variations and modifications are possible within the scope of the present invention.

Although Fig.4 shows a multi-chip module of an optoelectronic system, the present invention may also be advantageously applied to a monolithic integrated circuit.

Although Fig.3 shows an encapsulating substrate having a conducting layer over its whole surface for shielding purposes, in some cases it may be acceptable to provide transmission lines also on the encapsulating substrate, for example on the projections thereof which match the grooves in the first substrate.

Although methods have been described of forming grooves in a substrate or insulating layer thereon, the term "groove" may refer simply to the shape of the substrate. That is, a "grooved" surface morphology of the substrate could be formed merely by forming projections on a substrate without necessarily etching the substrate or insulating layer thereon.

Thus, in one embodiment, the present invention provides integrated transmission lines comprising:
a substrate having a step, the step further comprising a first surface in a first level, a second surface in a second level higher than the first level compared with a base level inside said substrate, and a side-wall,
the side-wall connecting with the first surface and the second surface therebetween,
a first transmission line formed on the first surface, and
a second transmission line formed on the second surface.

In another embodiment, there are provided integrated transmission lines comprising:
a substrate having a pair of steps on a surface of said substrate, the pair of the steps comprising a piece of a first surface in a first level, a pair of side-walls, and a pair of second surfaces in a second level, the first level being higher than the first level compared with a base level inside said substrate, the piece of the first surface being shared by a pair of the side-walls therebetween, and
each of the second surfaces having a transmission lines thereon.

Moreover, an embodiment of the present invention can provide a chip carrier comprising:
a substrate having a step on said substrate, said step further comprising a first surface in a first level, a second surface in a second level higher than the first level compared with a base level inside said substrate, and said side-wall so that the side-wall connects with the first surface and the second surface therebetween,
a first transmission line formed on the first surface,
a second transmission line formed on the second surface, and
a chip-stage formed on said substrate.

Another embodiment of the present invention can provide an integrated module comprising:
a substrate having a step on said substrate , said step further comprising a first surface in a first level, a second surface in a second level higher than the first level compared with a base level inside said substrate, and a side-wall,
the side-wall connecting with the first surface and the second surface therebetween,
a first transmission line formed on the first surface,
a second transmission line formed on the second surface,
a chip-stage formed on said substrate, and
a semiconductor chip bonded on the chip-stage and electrically connecting with the first and/or the second transmission lines.

## Claims

1. An integrated transmission line structure comprising:
a substrate having a step, the step defined by a first surface at a first level, a second surface at a second level which is higher than the first level relative to a base level of said substrate, and a side wall connecting the first surface to the second surface,
a first transmission line formed on the first surface, and
a second transmission line formed on the second surface.

2. The structure of claim 1, wherein the substrate has a plurality of said steps so as to form alternate grooves and projections on said substrate, each step having a respective said first and second transmission line formed on its first and second surfaces.

3. The structure of claim 1 or 2, wherein the substrate comprises an insulating material.

4. The structure of claim 1, 2 or 3, wherein an actual distance (A) between the or each first transmission line and its corresponding second transmission line is at least twice a horizontal distance (B) between them.

5. The structure of any preceding claim, further comprising an encapsulating substrate having a conducting layer on a surface thereof, and having a stepped shape complementary to that of said substrate, whereby, in use, said encapsulating substrate is engaged with said substrate so that said conducting layer is interposed between, but spaced apart from, said first and second transmission lines.

6. The structure of claim 5, wherein said encapsulating substrate comprises an insulating layer on the conducting layer.

7. The structure of any preceding claim, wherein said substrate has a conducting layer covered by an insulator.

8. An integrated transmission line structure comprising a plurality of transmission lines arranged parallel to each other on a substrate, each pair of adjacent transmission lines being separated by a groove.

9. The structure of claim 8, wherein said substrate comprises an insulating material in which the or each groove is formed.

10. The structure of claim 8 or 9, further comprising an encapsulating substrate having projections matching the grooves in said substrate and having a conducting layer on its surface, whereby, in use, said encapsulating substrate is engaged with said substrate so that the conducting layer is interposed between, but spaced apart from, the transmission lines.

11. The structure of claim 10, wherein an insulating layer is formed on said conducting layer.

12. The structure of claim 8, 9, 10, or 11, wherein the substrate has a conducting layer covered by an insulator.

13. The structure of any preceding claim, wherein the substrate is a chip carrier for forming a multi-chip module.

14. The structure of any preceding claim, further comprising a chip stage formed on said substrate, and a semiconductor chip bonded on the chip stage and electrically connected to one or more of the transmission lines, thereby forming an integrated module.

15. The structure of claim 14, wherein the semiconductor chip comprises an array of semiconductor devices.
